# FASCICULE DE BREVET EUROPEEN

(11) **EP 3 395 057 B1**
(45) Date de publication et mention de la délivrance du brevet: **18.09.2019**
(21) Numéro de dépôt: 16816409.3
(22) Date de dépôt: 13.12.2016
(51) Int. Cl.: H04N 5/225, B60Q 9/00, H05K 9/00

(54) **DISPOSITIF DE DÉTECTION ANTICOLLISION**
ERFASSUNGSVORRICHTUNG ZUR KOLLISIONSVERMEIDUNG
COLLISION-AVOIDANCE SENSING DEVICE

(30) Priorité: 22.12.2015 EP 15201854; 25.03.2016 CH 4012016
(43) Date de publication de la demande: 31.10.2018
(73) Titulaire: Swisstip SA, 1295 Tannay (CH)
(72) Inventeur: DE GAGNE, Marc, 08019 Barcelona (ES)
(74) Mandataire: Pronovem
(86) Numéro de dépôt international: PCT/IB2016/057557
(87) Numéro de publication internationale: WO 2017/109638

(56) Documents cités:
- WO-A1-2013/103548
- US-A1- 2010 328 644
- US-A1- 2012 113 317

## Description

### Objet de l'invention

La présente invention se rapporte au domaine de la détection anticollision. Elle se rapporte plus particulièrement à un dispositif de détection muni d'une caméra et de moyens permettant de limiter les interférences entre plusieurs composants du dispositif de détection.

### Arrière-plan technologique

Pour prévenir les collisions entre engins, entre engin et personnes ou encore entre engin et structures fixes, il est connu de munir les engins de systèmes de détection anticollision. Il existe plusieurs technologies (radar, onde radio, caméra, etc.) disponibles pour assurer la détection. On peut ainsi citer de nombreux documents, par exemple les documents US 7 167 082 et US 2011/0227747, divulguant des dispositifs de détection. Chaque technologie de détection est plus ou moins adaptée en fonction des conditions environnementales. Il est dès lors préférable de munir le dispositif de détection de plusieurs technologies.

Le document US 2010/0328644 divulgue un dispositif anticollision comprenant un module caméra et un module de détection LIDAR. Le document US 2012/0113317 divulgue un module caméra enfermé dans un boîtier métallique, qui le protège des interférences électromagnétiques.

Les caméras deviennent obligatoires ou du moins systématiquement installées sur les équipements mobiles, les équipements de constructions, les équipements de logistique, ou, de manière générale, sur tout véhicule impliqué là où il y a un risque de collision. A elles seules, les caméras ne peuvent assurer la visibilité nécessaire. En conséquence, différents appareils de détection sont installés séparément, ce qui complique l'installation. Il est donc préférable d'installer la caméra au sein d'un même appareil comprenant tous les composants de détection. Cela pose cependant plusieurs problèmes comme expliqué ci-dessous.

Les caméras de surveillance requièrent un temps de réponse instantané et, ce, surtout dans le cas de la sécurité des engins et des personnes lorsque l'image doit être immédiatement disponible à l'opérateur. Dès lors, les caméras vidéo analogiques ayant un temps de réponse instantané sont privilégiées par rapport aux caméras digitales. Un signal vidéo analogique combine sur un même fil l'information nécessaire pour reproduire l'image couleur ou noir et blanc ainsi que les signaux de synchronisation de l'image. Toute forme de bruit sur cette ligne affecte la qualité de l'image reçue, la couleur et la synchronisation des images. Lorsque la caméra est intégrée dans un ensemble électronique de faible dimension qui comprend d'autres modules dont des modules de radiofréquences, des antennes, des détecteurs divers (laser, infra-rouge, ultra-son, etc.) et un bloc d'alimentation, les interférences entre les différents composants risquent d'affecter la qualité de l'image reçue et d'impacter sur le fonctionnement des différents composants.

### Buts de l'invention

La présente vise à inclure plusieurs composants de détection au sein d'un seul boitier petit et intégré pour répondre au mieux aux besoins de détection de risques d'accidents tout en évitant les interférences entre les différents composants.

La présente invention vise ainsi à développer un dispositif de détection basé sur un ensemble de différentes technologies de détection, le tout combiné avec un processeur, qui permettent de cibler intelligemment le risque de collisions.

### Brève description des figures

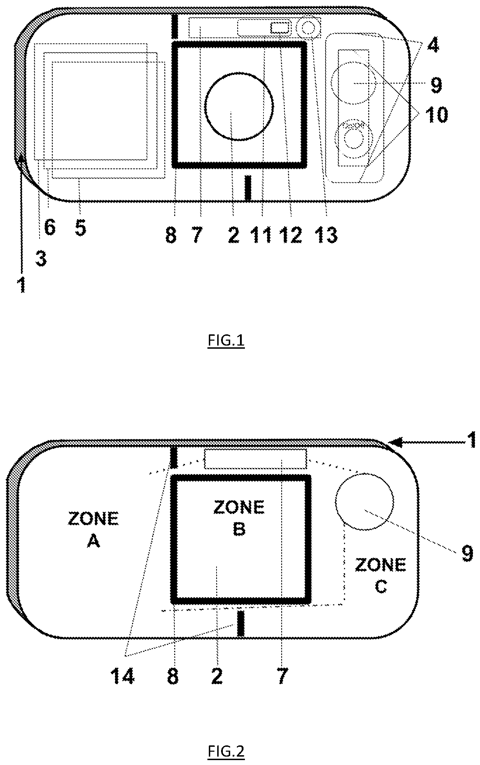

Les caractéristiques et avantages de la présente invention apparaîtront à la lecture de la description détaillée ci-dessous faisant référence aux figures 1 et 2.

De manière schématique, la figure 1 représente le boîtier selon l'invention comportant les différents systèmes de détection et les éléments nécessaires à leur fonctionnement.

La figure 2 représente schématiquement les différentes zones au sein du boîtier selon l'invention.

### Légende

- (1): Boîtier

- (2): Module caméra
- (3): Module RF
- (4): Module de détection incluant les capteurs additionnels
- (5): Module OSD
- (6): Module CPU
- (7): Bloc d'alimentation
- (8): Zone métallique enfermant la caméra
- (9): Connecteur multi-pin
- (10): PCB dédié au connecteur multi-pin
- (11): Convertisseur abaisseur
- (12): Commutateur
- (13): Condensateur
- (14): Paroi métallique

### Principaux éléments caractéristiques de l'invention

La présente invention se rapporte à un dispositif de détection anticollision selon la revendication 1, qui est notamment formé d'un boîtier comprenant un premier module qui est un module caméra, de préférence analogique, et d'un second module de détection basé sur une quelconque technologie de détection anticollision.

Selon des modes particuliers de l'invention, le dispositif de détection comporte au moins une ou une combinaison appropriée des caractéristiques suivantes :
- le boîtier a un volume inférieur à 1.7 dm³, de préférence inférieur à 1.2 dm³ et, plus préférentiellement inférieur à 1dm³ ;
- le second module est un module de détection par radiofréquence ;
- le boîtier comprend en outre un troisième module de détection comprenant un ou plusieurs capteurs ;
- le boîtier comprend également un module OSD qui permet de manipuler l'image de la caméra pour y ajouter un message texte et un module CPU gérant l'ensemble des données issues des modules ;
- le bloc d'alimentation est séparé du second module par l'enveloppe métallique du module caméra et, optionnellement, par une ou plusieurs paroi(s) métallique(s) ;
- le bloc d'alimentation est également séparé du module OSD et du module CPU par ladite enveloppe métallique du module caméra et, optionnellement, par ladite ou lesdites paroi(s) ;
- le module CPU est positionné entre le module OSD et le second module afin de limiter les interférences entre ledit module OSD et ledit second module ;
- le bloc d'alimentation est conçu par phase, et de préférence en 4+1 phases, chaque phase étant indépendante avec une sortie munie de moyens de filtration pour limiter le bruit en sortie à une valeur inférieure à 50 mV et, de préférence, inférieure à 30mV ;
- une phase est destinée à gérer exclusivement une arrivée électrique dans le boîtier et comprend un commutateur et un condensateur de capacité supérieure à 90µF et, de préférence supérieure à 100µF, pour limiter les bruits en sortie de ladite phase ;
- une autre phase assure une alimentation électrique indépendante de chaque module ;
- des lignes électriques et des lignes de transmission de données et signaux sont perpendiculaires entre elles et/ou éloignées pour éviter des phénomènes d'induction entre lignes;
- des lignes de transmission de données et signaux et des lignes électriques sont respectivement positionnées de part et d'autre de l'enveloppe métallique du module caméra.

La présente invention se rapporte également au véhicule comprenant le dispositif de détection tel que décrit ci-dessus.

### Description de l'invention

Le dispositif de détection selon l'invention comporte plusieurs composants intégrés au sein d'un même boîtier de petite taille. On entend par petite taille, un boîtier de volume inférieur à 1.7 dm³, de préférence inférieur à 1.2 dm³, et, encore plus préférentiellement, à 1 dm³. Par exemple, les trois dimensions sont de l'ordre de 200 mm de large, sur 100 mm de haut et 60 mm de profondeur.

Selon l'invention, le dispositif de détection forme un seul boîtier avec en son sein une conception modulaire où chaque module remplit une fonction. Comme expliqué plus loin, les modules sont protégés des interférences électromagnétiques extérieures et agencés au sein du boîtier de manière à limiter les interférences entre modules. Une attention particulière est également portée au bloc d'alimentation électrique du boîtier et à ses composants, toujours dans le but de limiter les interférences et bruits susceptibles d'affecter le fonctionnement des modules et la qualité des signaux.

Le boîtier 1 visible à la figure 1 comporte un premier composant de détection qui est une caméra, et de préférence, une caméra analogique formant le module caméra 2. Ce module intègre la caméra, son circuit et, éventuellement, des LED's permettant la vision de nuit.

Le boîtier 1 comporte en outre au moins un second composant de détection basé sur une technologie radar, radiofréquence (RF), ultrason, micro-laser, distinction infra-rouge, etc. De préférence, le second composant est basé sur une technologie de détection RF et forme le module RF 3 incluant l'antenne.

Le module caméra et le module RF sont les deux modules qui assurent la détection anticollision de base. En outre, le dispositif peut optionnellement être muni de composants de détection additionnels regroupés au sein d'un ou plusieurs modules qualifiés, de manière générale, de modules de détection 4. Ce ou ces modules optionnels peuvent comporter un ou plusieurs des capteurs ou émetteurs suivants:
∘ détecteur de personnes,
∘ capteur de mouvement,
∘ capteur de vitesse,
∘ capteur d'inclinaison,
∘ capteur de température,
∘ alarme de recul,
∘ alarme de mise en marche du véhicule,
∘ etc.

Le boîtier 1 comporte un bloc d'alimentation 7 assurant l'alimentation électrique des différents modules et comporte un processeur 6 destiné à analyser les données issues de l'ensemble des composants de détection, appelé module CPU.

En outre, le boîtier peut être muni d'un module OSD 5 (On Screen Display) qui permet de manipuler l'image de la caméra pour y ajouter un message texte comme, par exemple, ALARME lorsque le dispositif détecte un risque d'accident. Positionner le module OSD à l'intérieur du boîtier permet d'éviter tout circuit externe et trop de communications entre le dispositif de détection et le moniteur vidéo. Le boîtier peut également, à titre optionnel, comporter un module de transmission RF pour la transmission sans fil du signal vidéo, ce module (non représenté) peut être directement intégré dans le module OSD ou être intégré dans un module distinct.

Pour isoler l'ensemble du boîtier des champs EM extérieurs, le boîtier est soit entièrement en métal ou sa surface est métallisée pour agir comme une cage de Faraday. De plus, le module caméra 2 particulièrement sensible aux interférences issues des autres modules et du bloc d'alimentation est entièrement monté dans sa propre zone 8 métallique fermée et isolée formant un module métallisé au sein du boîtier. Ainsi, la caméra, le circuit de la caméra et les LED's si présentes sont assemblées dans un boîtier 8 à l'intérieur du boîtier 1.

De préférence, l'ensemble des modules et le bloc d'alimentation sont également agencés de manière particulière au sein du boîtier 1 afin de limiter les interférences. A la figure 2, le boîtier 1 est schématiquement divisé en trois zones A, B et C. La zone A comporte les modules particulièrement sensibles aux bruits, à savoir le module RF 3, le module CPU 6 et le module OSD 5. La zone B disposée entre la zone A et la zone C comporte le module caméra 2 formant une cage de Faraday. En fonction de l'agencement et des dimensions du boîtier, un ou plusieurs écrans métalliques 14 peuvent optionnellement être placés pour délimiter la zone A de la zone C. La zone C comporte le bloc d'alimentation 7 et les éléments moins sensibles aux bruits électriques et aux interférences, à savoir, dans l'exemple illustré, le module de détection 4. Cette zone C comporte le bloc d'alimentation qui est particulièrement critique car il génère beaucoup de bruit. Elle est dès lors positionnée le plus loin possible de la zone A avec la cage métallique de la zone B faisant écran entre les deux. Au sein de la zone A, pour limiter les interférences entre le module OSD et le module RF, il est préférable de positionner le module CPU entre les deux modules. Le module OSD est ainsi plus proche du couvercle de métal extérieur et donc bien encadré pour protéger le signal vidéo et éviter les interférences avec les parties sensibles de l'ensemble. Alternativement, le module OSD pourrait être conçu comme un module complètement indépendant et isolé dans son propre boîtier au sein du boîtier général, le boîtier étant métallique ou couvert d'époxy électrique et ensuite blindé d'une couche de métal. Pour finir en ce qui concerne l'agencement des différentes zones, on précisera que, sur la figure 2, la zone A et la zone C sont respectivement positionnées à gauche et à droite mais toute configuration est envisageable tant que la zone B est intercalée entre les zones A et C.

Outre le blindage métallique du boîtier et du module caméra et le regroupement particulier des modules au sein du boîtier, l'isolation électromagnétique des différents modules peut être renforcée en prenant une ou plusieurs des mesures suivantes :
- Un ou plusieurs des modules, hormis le module caméra, comprend une couche de cuivre passive pour assurer un bon isolement des inductions.
- Les lignes de conduite de signaux sont préférentiellement blindées.
- Les lignes de transmission et les lignes électriques sont préférentiellement perpendiculaires les unes aux autres afin d'avoir un impact nul sur l'induction d'une ligne voisine. A cet effet, le boîtier 1 comporte un seul connecteur multi-pin 9 incluant la ligne de transmission vidéo et la lignée d'entrée haut voltage qui est monté sur un PCB propre 10 (voir figure 1), une trace sur PCB permettant de mieux maîtriser la direction des lignes comparé à des fils soudés. La ligne de transmission vidéo est ainsi orientée perpendiculairement aux lignes électriques de sorte à éviter l'induction directe. Il est également envisageable que les lignes de transmission schématisées par des traits discontinus à la figure 2 soient positionnées du côté opposé au bloc d'alimentation et aux lignes électriques (schématisées par des pointillés). Il est aussi envisageable de combiner des lignes perpendiculaires et des lignes éloignées. Il est en outre envisageable d'utiliser deux connecteurs distincts pour respectivement les lignes électriques et les lignes de transmission.
- Les bruits sont éliminés à chacun des points de source de bruit avec filtre ou circuit de traitement du signal, pour en éviter dès la source, la propagation, car chaque source de bruit produit son effet unique. En effet, si non traité à la source, il devient difficile, sinon impossible de nettoyer le signal à la destination. Ainsi, un filtrage et/ou un circuit de correction indépendant est prévu à chaque sortie de signal data, signal vidéo, signal RF et alimentation électrique plutôt qu'une seule fois, de sorte à obtenir un filtrage/correction ciblée selon chaque risque spécifique au module et à ne traiter que des lignes propres en entrée de tout module et assurer une sortie propre de chaque module. On évite ainsi de cumuler les bruits et distorsions.
- Selon l'invention, on veille en outre à ce que tous les circuits soient fermés afin de limiter les fuites inductives. Pour se faire, toutes les lignes de transmission et toutes les lignes de haute vitesse sont terminées. Les traces à haute vitesse ont une terminaison avec résistance ou un point de ferrite pour assurer le circuit fermé.

Toujours dans le but de réduire le bruit, une attention particulière est portée au bloc d'alimentation 7 qui crée des impulsions électromagnétiques très puissantes qui sont susceptibles d'interférer avec le signal vidéo ainsi qu'avec le module RF. Comme déjà mentionné, il est dès lors positionné le plus loin possible des circuits de traitement de l'image vidéo, à savoir du module OSD 5 et du module de transmission RF du signal vidéo s'il est présent. En outre, pour limiter les bruits causés par le bloc d'alimentation ainsi que pour assurer une alimentation propre et stable, le bloc d'alimentation est conçu par phase, chaque phase étant indépendante, avec une seule sortie via un système de filtre ou de circuit de protection pour nettoyer la sortie à chaque phase. De préférence, le bloc d'alimentation est conçu en 4 + 1 (neutre) phases.

La première phase gère exclusivement l'arrivée électrique. Cette phase est particulièrement critique car elle comprend deux composants produisant des impulsions EM assez puissantes et donc susceptibles de causer du bruit à l'intérieur du boîtier et à la caméra, voire même à tous les circuits et les détecteurs divers. Les deux composants sont le commutateur 12 (switcher) et le condensateur 13 qui accompagne le commutateur. Il faut savoir que le dispositif de détection selon l'invention est conçu pour l'industrie. Cela signifie que le petit boîtier doit pouvoir prendre un gros courant et un voltage d'entrée allant de 10-11 Volts à 60 Volts selon le type de véhicule. Pour produire une alimentation stable, le bloc d'alimentation utilise un convertisseur abaisseur 11 (step down converter) qui produit 8V à partir d'une source externe qui varie entre 9V et 60V. Le stress électrique le plus important est donc en entrée sur le commutateur 12 et le condensateur 13, lorsque ce dernier allume et éteint le courant plusieurs fois par seconde ainsi que lors de la mise en marche générale. Pour réduire les interférences au sein du boîtier, ces composants sont positionnés juste à côté du connecteur 9 externe du boîtier, ce qui permet de limiter la longueur de ligne à l'intérieur. Ils sont en outre isolés et installés dans leur propre section sur un PCB. Comme déjà mentionné précédemment, ils sont localisés du côté opposé aux circuits de traitement de l'image vidéo et séparés de ces derniers par un bloc de métal qui contient la caméra. En outre, pour réduire la propagation de variations électriques émettrices de bruit, un gros condensateur 13 est utilisé de telle sorte que le courant cumulé qui passe par le commutateur reste stocké le plus longtemps possible, voire isolé totalement de la ligne de transmission principale puis que le condensateur devienne la seule source de sortie. Ce design est nouveau, la spécification du condensateur d'entrée est bien au-delà des spécifications de design, dans le but d'assurer une alimentation soutenue en sortie et isolant totalement le commutateur du reste de l'appareil. A cet effet, la capacité du condensateur est de minimum 90µF et, de préférence, de l'ordre de 100µf. Il est ainsi possible lors de la première phase de limiter les bruits en sortie à des valeurs inférieures à 50mV pour un voltage de sortie constant de 8V. La sortie est unique et débouche sur la phase suivante.

Les deuxième et troisième phases servent à la régulation de différents voltages, de filtres, de protections et du chargeur de batterie interne lorsqu'utilisé. Plus précisément, à la deuxième phase, un contrôleur gère les besoins du réseau électrique interne et le chargeur de batterie s'il y en a une. La sortie est filtrée pour limiter le bruit à moins de 30mV. A la troisième phase, un contrôleur DC/DC adapte le voltage précisément pour chaque module. En sortie, le voltage est constant indépendamment d'éventuelles variations de charges sur le réseau électrique interne au boîtier. Les bruits sont filtrés et inférieurs à 30mV, voire 20mV.

La quatrième phase se retrouve dans chaque module, chaque module ayant son propre régulateur classique. Cette phase se retrouve installée sur chaque module pour assurer un voltage exact par module adapté aux besoins de chacun. Ainsi, chaque module est indépendant électriquement et gère ses propres signaux, avec si besoin son propre microcontrôleur.

En résumé, le dispositif de détection anticollision selon l'invention présente les avantages suivants :
- Il est de petite taille tout en intégrant tous les composants nécessaires à la détection anticollision.
- Il présente une isolation RF et électrique par module plutôt qu'une seule isolation de tout le dispositif.
- Les mesures d'isolation RF et électrique permettent d'assurer un fonctionnement optimum des différents modules et garantissent la qualité du signal vidéo.
- Chaque composant de détection est conçu sous forme de module fermé et isolé avec la phase finale d'alimentation qui est un régulateur de voltage en interne de chaque module pour tenir les variations de voltage dues à la charge totale sur le réseau.
- Il présente une capacité électrique surdimensionnée pour assurer à chaque phase une seule source de sortie sans compensation car toute compensation comprend toujours des variations cycliques génératrices de bruit EM.
- Le bloc d'alimentation est intégré dans le boîtier, ce qui permet d'éviter un bloc d'alimentation externe qui rendrait l'installation compliquée. La qualité de l'alimentation serait en outre affectée par la longueur du fil et par les différents éléments présents autour sur les véhicules.
- Grâce aux éléments d'isolations anti-EM à l'intérieur du boîtier, la direction du balayage RF du module de détection radiofréquence peut être maîtrisée par le seul design de l'antenne sans risque d'interférence.

La présente invention a été plus particulièrement détaillée pour un système de détection comprenant une caméra en sus d'un ou plusieurs autres composants de détection. Cependant, les moyens mis en oeuvre pour limiter les interférences sont d'application même en l'absence de caméra. En effet, chaque composant de détection a sa fragilité et sensibilité pour être efficace. Mettre ensemble des lignes d'entrée de détection divers (signal de recul par exemple) d'une machine dont l'entrée est d'un haut voltage instable, avec un module RF, des pulseurs infra-rouge ou laser, des senseurs de mouvements et d'inclinaison avec un chargeur de batterie, le tout avec une charge électrique variant beaucoup, requiert les mêmes moyens pour limiter les interférences entre composants que lors de l'intégration d'une caméra même si les risques de perturbation ne sont pas les mêmes, un signal vidéo analogique étant plus fragile.

En outre, la présente invention a été plus particulièrement détaillée pour un système de détection comprenant une caméra analogique mais la présente invention s'applique également à une caméra digitale qui même si peu utilisée car trop lente est également sensible aux bruits lorsqu'elle est trop proche de systèmes électriques divers, champs EM, etc.

## Revendications

1. Dispositif de détection anticollision formé d'un boîtier (1) comprenant un premier module qui est un module caméra (2), de préférence analogique, et un second module (3) de détection basé sur une quelconque technologie de détection anticollision et un bloc d'alimentation (7) électrique, ledit boîtier (1) formant une enveloppe métallique protégeant l'intérieur du boîtier (1) des interférences électromagnétiques issues de l'extérieur, le module caméra (2) étant en outre placé dans sa propre enveloppe métallique (8) à l'intérieur dudit boîtier (1) afin de le protéger des interférences électromagnétiques internes, ledit bloc d'alimentation (7) électrique étant séparé du second module (3) par l'enveloppe métallique (8) du module caméra (2) faisant écran entre le bloc d'alimentation (7) électrique et le second module (3) de détection afin de limiter les bruits et les interférences du bloc d'alimentation (7) électrique sur le second module (3) de détection et, optionnellement, par une ou plusieurs paroi(s) métallique(s) (14).

2. Dispositif selon la revendication 1, dans lequel le boîtier (1) a un volume inférieur à 1.7 dm³, de préférence inférieur à 1.2 dm³ et, plus préférentiellement inférieur à 1dm³.

3. Dispositif selon l'une quelconque des revendications précédentes, dans lequel le second module (3) est un module de détection par radiofréquence.

4. Dispositif selon l'une quelconque des revendications précédentes, comprenant en outre un troisième module de détection (4) comprenant un ou plusieurs capteurs.

5. Dispositif selon l'une quelconque des revendications précédentes, dans lequel le boîtier (1) comprend également un module OSD (5) qui permet de manipuler l'image de la caméra pour y ajouter un message texte et un module CPU (6) gérant l'ensemble des données issues des modules (2,3,4,5).

6. Dispositif selon la revendication 5, dans lequel le bloc d'alimentation (7) est également séparé du module OSD (5) et du module CPU (6) par ladite enveloppe métallique (8) du module caméra (2) et, optionnellement, par ladite ou lesdites paroi(s) (14).

7. Dispositif selon l'une quelconque des revendications 5 à 6, dans lequel le module CPU (6) est positionné entre le module OSD (5) et le second module (3) afin de limiter les interférences entre ledit module OSD (5) et ledit second module (3).

8. Dispositif selon l'une quelconque des revendications précédentes, dans lequel le bloc d'alimentation (7) est conçu par phase, et de préférence en 4+1 phases, chaque phase étant indépendante avec une sortie munie de moyens de filtration pour limiter le bruit en sortie à une valeur inférieure à 50 mV et, de préférence, inférieure à 30mV.

9. Dispositif selon la revendication 8, dans lequel une phase est destinée à gérer exclusivement une arrivée électrique dans le boîtier (1) et comprend un commutateur (12) et un condensateur (13) de capacité supérieure à 90µF et, de préférence supérieure à 100µF, pour limiter les bruits en sortie de ladite phase.

10. Dispositif selon la revendication 8 ou 9, dans lequel une autre phase assure une alimentation électrique indépendante de chaque module (2,3,4,5,6).

11. Dispositif selon l'une quelconque des revendications précédentes, dans lequel des lignes électriques et des lignes de transmission de données et signaux sont perpendiculaires entre elles et/ou éloignées pour éviter des phénomènes d'induction entre lignes.

12. Dispositif selon l'une quelconque des revendications précédentes, dans lequel des lignes de transmission de données et signaux et des lignes électriques sont respectivement positionnées de part et d'autre de l'enveloppe métallique (8) du module caméra (2).

13. Véhicule comprenant le dispositif de détection selon l'une quelconque des revendications précédentes.

## Patentansprüche

1. Erfassungsvorrichtung zur Kollisionsvermeidung, gebildet aus einem Gehäuse (1), umfassend ein erstes Modul, das ein vorzugsweise analoges Kameramodul (2) ist, und ein zweites Erfassungsmodul (3), basierend auf einer beliebigen Antikollisionserfassungstechnologie, und einen elektrischen Versorgungsblock (7), wobei das Gehäuse (1) eine Metallhülle bildet, die das Innere des besagten Gehäuses (1) vor elektromagnetischen Interferenzen von außen schützt, wobei das Kameramodul (2) ferner in seiner eigenen Metallhülle (8) im Inneren des Gehäuses (1) platziert ist, um es vor internen elektromagnetischen Interferenzen zu schützen, wobei der besagte elektrische Versorgungsblock (7) vom zweiten Modul (3) durch die Metallhülle (8) des Kameramoduls (2) getrennt ist, die zwischen dem elektrischen Versorgungsblock (7) und dem zweiten Erfassungsmodul (3) einen Schirm bildet, um das Rauschen und die Interferenzen des elektrischen Versorgungsblocks (7) auf das zweite Erfassungsmodul (3) zu begrenzen, und optional durch eine oder mehrere Metallwand(-wände) (14).

2. Vorrichtung nach Anspruch 1, wobei das Gehäuse (1) ein Volumen unter 1,7 dm³, vorzugsweise unter 1,2 dm³ und noch bevorzugter unter 1 dm³ hat.

3. Vorrichtung nach irgendeinem der vorangehenden Ansprüche, wobei das zweite Modul (3) ein Erfassungsmodul durch Funkfrequenz ist.

4. Vorrichtung nach irgendeinem der vorangehenden Ansprüche, umfassend ferner ein drittes Erfassungsmodul (4), umfassend einen oder mehrere Sensoren.

5. Vorrichtung nach irgendeinem der vorangehenden Ansprüche, wobei das Gehäuse (1) ebenfalls ein OSD-Modul (5) umfasst, das erlaubt, das Bild der Kamera zu verändern, um dort eine Textnachricht hinzuzufügen, und ein CPU-Modul (6), welches alle Daten aus den Modulen (2, 3, 4, 5) verwaltet.

6. Vorrichtung nach Anspruch 5, wobei der Versorgungsblock (7) ebenfalls von dem OSD-Modul (5) und dem CPU-Modul (6) durch die Metallhülle (8) des Kameramoduls (2) und optional durch die besagte(n) Metallwand-(wände) (14) getrennt ist.

7. Vorrichtung nach irgendeinem der Ansprüche 5 bis 6, wobei das CPU-Modul (6) zwischen dem OSD-Modul (5) und dem zweiten Modul (3) positioniert ist, um die Interferenzen zwischen dem besagten OSD-Modul (5) und dem besagten zweiten Modul (3) zu begrenzen.

8. Vorrichtung nach irgendeinem der vorangehenden Ansprüche, wobei der Versorgungsblock (7) je Phase und vorzugsweise in 4+1 Phasen konzipiert ist, wobei jede Phase unabhängig ist mit einem Ausgang, ausgestattet mit Filtermitteln, um das Rauschen am Ausgang auf einen Wert unter 50 mV und vorzugsweise unter 30 mV zu begrenzen.

9. Vorrichtung nach Anspruch 8, wobei eine Phase zur exklusiven Verwaltung einer elektrischen Zufuhr in das Gehäuse (1) bestimmt ist und einen Umschalter (12) und einen Kondensator (13) mit einer Kapazität über 90 µF und vorzugsweise über 100 µF umfasst, um das Rauschen am Ausgang der besagten Phase zu begrenzen.

10. Vorrichtung nach Anspruch 8 oder 9, wobei eine andere Phase eine von jedem Modul (2, 3, 4, 5, 6) unabhängige elektrische Versorgung gewährleistet.

11. Vorrichtung nach irgendeinem der vorangehenden Ansprüche, wobei elektrische Leitungen und Signal- und Datenübertragungsleitungen zueinander senkrecht und/oder beabstandet sind, um Induktionserscheinungen zwischen Leitungen zu vermeiden.

12. Vorrichtung nach irgendeinem der vorangehenden Ansprüche, wobei Signal- und Datenübertragungsleitungen und elektrische Leitungen jeweils auf der einen und der anderen Seite der Metallhülle (8) des Kameramoduls (2) positioniert sind.

13. Fahrzeug, umfassend die Erfassungsvorrichtung nach irgendeinem der vorangehenden Ansprüche.

## Claims

1. A collision detection device made up of a housing (1) comprising a first module that is a camera module (2), preferably analog, and a second detection module (3) based on any collision detection technology and an electric supply block (7), said housing (1) forming a metal enclosure protecting the inside of the housing (1) from electromagnetic interference coming from the outside, the camera module (2) further being placed in its own metal enclosure (8) inside said housing (1) in order to protect it from internal electromagnetic interference, said electric supply block (7) being separated from the second module (3) by the metal enclosure (8) of the camera module (2) forming a screen between the electric supply block (7) and the second detection module (3) so as to limit the noises and the interference of the electric supply block (7) on the second detection module (3), and, optionally, by one or several metal wall(s) (14).

2. Device according to claim 1, wherein the housing (1) has a volume smaller than 1.7 dm³, preferably smaller than 1.2 dm³ and more preferably smaller than 1 dm³.

3. Device according to any one of the preceding claims, wherein the second module (3) is a radiofrequency detection module.

4. Device according to any one of the preceding claims, further comprising a third detection module (4) comprising one or several sensors.

5. Device according to any one of the preceding claims, wherein the housing (1) also comprises an OSD module (5) that makes it possible to manipulate the image from the camera in order to add a text message thereto and a CPU module (6) managing all of the data coming from the modules (2,3,4,5).

6. Device according to claim 5, wherein the supply block (7) is also separated from the OSD module (5) and the CPU module (6) by said metal enclosure (8) of the camera module (2) and, optionally, by said wall(s) (14).

7. Device according to any one of claims 5 to 6, wherein the CPU module (6) is positioned between the OSD module (5) and the second module (3) in order to limit the interference between said OSD module (5) and said second module (3).

8. Device according to any one of the preceding claims, wherein the supply block (7) is designed by phase, and preferably in 4+1 phases, each phase being independent with an output provided with filtration means in order to limit the output noise to a value below 50 mV, and, preferably, below 30 mV.

9. Device according to claim 8, wherein a phase is intended exclusively to manage an electrical input in the housing (1) and comprises a switch (12) and a capacitor (13) with a capacitance greater than 90 µF, and preferably greater than 100 µF, in order to limit the noises at the output of said phase.

10. Device according to claim 8 or 9, wherein another phase ensures an independent electrical supply of each module (2,3,4,5,6).

11. Device according to any one of the preceding claims, wherein electrical lines and data and signal transmission lines are perpendicular to and/or remote from one another in order to avoid induction phenomena between lines.

12. Device according to any one of the preceding claims, wherein data and signal transmission lines and electrical lines are respectively positioned on either side of the metal enclosure (8) of the camera module (2).

13. Vehicle comprising the detection device according to any one of the preceding claims.
